# EUROPEAN PATENT APPLICATION

(11) **EP 4 328 181 A1**
(43) Date of publication of application: **28.02.2024**
(21) Application number: 23192080.2
(22) Date of filing: 18.08.2023
(51) Int. Cl.: C01B 32/956, C01B 32/963, C01B 32/984

(54) **SILICON CARBIDE POWDER, METHOD FOR MANUFACTURING THE SAME AND METHOD FOR MANUFACTURING SILICON CARBIDE INGOT USING THE SAME**

(30) Priority: 22.08.2022 KR 20220104820
(71) Applicant: SENIC Inc., Seobuk-gu Cheonan-si, Chungcheongnam-do 31040 (KR)
(72) Inventor: PARK, Jong Hwi, 16278 Suwon-si, Gyeonggi-do (KR); KYUN, Myung Ok, 16327 Suwon-si, Gyeonggi-do (KR)
(74) Representative: Isarpatent

(57) **Abstract**

A silicon carbide powder including carbon; silicon; and an oxide film having a thickness of 0.1 nm to 10 nm.

## Description

### Technical Field

An embodiment relates to a silicon carbide powder, a method for manufacturing the same and a method for manufacturing a silicon carbide ingot using the same.

### Background Art

Silicon carbide (SiC) has excellent heat resistance and mechanical strength, is highly resistant to radiation, and can be used even to produce large-diameter substrates. In addition, silicon carbide has excellent physical strength and chemical resistance, a large energy band gap, and a large electron saturation drift rate and pressure resistance. Accordingly, silicon carbide is widely used in abrasives, bearings, fireproof plates, and the like as well as semiconductor devices that require high power, high efficiency, high voltage resistance, and high capacity.

Silicon carbide is manufactured through various methods such as heat treatment or electrification of carbon raw materials such as silicon carbide waste. Examples of conventional methods include the Acheson method, a reactive sintering method, an atmospheric pressure sintering method, and a chemical vapor deposition (CVD) method. In these methods, carbon raw materials remain. These residues act as impurities and may deteriorate the thermal, electrical, and mechanical properties of silicon carbide.

For example, Japanese Patent Publication No. 2002-326876 discloses a method of reacting a silicon carbide precursor, which has undergone a heat treatment process, at a high temperature under an inert gas condition such as argon (Ar) to polymerize or cross-link a silicon source and a carbon source. However, this process has problems in that the manufacturing cost is high and the size of the powder is not uniform due to heat treatment at a high temperature of 1,800°C to 2,100°C under a vacuum or inert gas condition.

Moreover, wafers used in the solar cell and semiconductor industries are manufactured by growing from silicon ingots in a crucible made of graphite or the like and, during this manufacturing process, a significant amount of silicon carbide waste, adsorbed on the inner wall of the crucible, as well as a waste slurry containing silicon carbide is generated. However, landfill disposal of such waste has caused environmental problems which can result in high disposal costs.

### SUMMARY

In one embodiment of the present disclosure, there is provided a silicon carbide powder with improved purity and fewer defects used to manufacture a silicon carbide ingot and a method of manufacturing the silicon carbide ingot.

In accordance with one aspect of the present disclosure, there is provided a silicon carbide powder, including: carbon; silicon, an oxide film having a thickness of 0.1 nm to 10 nm.

In one embodiment, the silicon carbide powder may include a core including silicon carbide that is a compound of the carbon and the silicon, and the oxide film may be disposed around the core.

In another embodiment, a thickness of the oxide film may be 0.5 nm to 8 nm.

In another embodiment, a thickness of the oxide film may be 0.7 nm to 6 nm.

The silicon carbide powder according to one embodiment may have an average particle diameter (D50) ranging from about 100 µm to about 1000 µm.

In the silicon carbide powder according to another embodiment, a ratio of the oxide film thickness relative to the average particle diameter may be 1×10⁻⁷ to 1×10⁻⁵.

In the silicon carbide powder according to another embodiment, O1s/Si2p of a surface measured by X-ray photoelectron spectroscopy may be 0.39 or less, and O1s/C1s of the surface measured by X-ray photoelectron spectroscopy may be 0.28 or less.

In one embodiment, there is provided a method of manufacturing a silicon carbide powder, the method including: providing a raw material including silicon carbide; powdering the raw material; and surface-treating the powdered raw material to form an oxide film having a thickness of 0.1 nm to 10 nm.

In another embodiment, the surface-treating of the powdered raw material may include immersing the surface of the raw material in a surface treatment liquid.

In another embodiment, in the surface-treating of the powdered raw material, the surface treatment liquid may include citric acid.

It is yet another embodiment of the present disclosure, there is provided a method of manufacturing a silicon carbide wafer, the method including: preparing a silicon carbide powder including carbon, silicon and an oxide film having a thickness of 0.1 nm to 10 nm; growing a silicon carbide ingot using the silicon carbide powder; and processing the silicon carbide ingot.

### Description of Drawings

FIG. 1 is a flowchart illustrating a manufacturing process of a silicon carbide powder according to one embodiment.
FIG. 2 is a flowchart illustrating a manufacturing process of a silicon carbide powder according to another embodiment.
FIG. 3 is a flowchart illustrating a manufacturing process of a silicon carbide powder according to another embodiment.
FIG. 4 is a flowchart illustrating a manufacturing process of a silicon carbide powder according to another embodiment.
FIG. 5 is a flowchart illustrating a manufacturing process of a silicon carbide powder according to another embodiment.
FIG. 6 is a flowchart illustrating a manufacturing process of a silicon carbide powder according to another embodiment.
FIG. 7 is a sectional view illustrating a cross-section of a silicon carbide powder according to another embodiment.
FIG. 8 is a sectional view illustrating a process of growing a silicon carbide ingot.

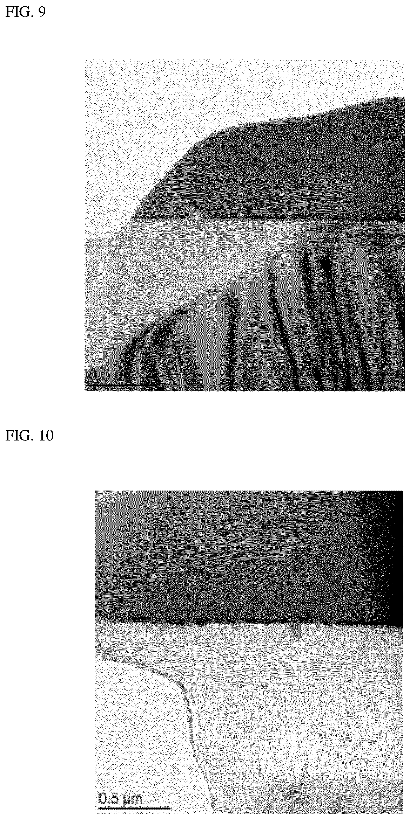

FIG. 9 illustrates a cross-section of a silicon carbide powder manufactured according to Example 1.
FIG. 10 illustrates a cross-section of a silicon carbide powder manufactured according to Example 2.

Detailed DescriptionHereinafter, the invention will be described in detail through the described embodiments. The described embodiments are not limited to contents disclosed below and may be modified in various forms.

In the present specification, unless otherwise specified, when a part "comprises" a certain component, it means that other components may be further included, rather than excluding other components.

It should be understood that all numbers and expressions indicating the amounts of components, reaction conditions, etc. described in this specification are modified by the term "about" in all cases unless otherwise specified. The term "about" refers to variations in the magnitude of the quantity described of +/-2%.

It should be understood that, for the ranges described, the present disclosure includes all intermediate values and sub-ranges within the specified range described.

In one embodiment, there is provided a silicon carbide powder including an oxide film having an appropriate thickness. In particular, the surface of the silicon carbide powder according to this embodiment can include an oxide film having an appropriate thickness.

Accordingly, the silicon carbide powder according to one embodiment can protect the interior from external impurities. Accordingly, the silicon carbide powder according to one embodiment can be appropriately used as a raw material for manufacturing silicon carbide.

In addition, when a silicon carbide ingot and a silicon carbide wafer are manufactured using the silicon carbide powder of the present disclosure, the thickness of the oxide film is of an appropriate thickness so that a reduced number of defects occur in the resultant silicon carbide ingot and the silicon carbide wafer made from the silicon carbide powder of the present disclosure.

In particular, since the surface of the silicon carbide powder includes an oxide film with an appropriate thickness, the oxide film can be removed in an initial heat treatment step inside an apparatus for growth of the silicon carbide ingot. Accordingly, the oxide film on the surface of the silicon carbide powder can be removed with the initial heat treatment process, and defects due to remaining oxygen on the surface of the silicon carbide powder used in a physical vapor deposition process for growth of the silicon carbide ingot can be minimized.

In addition, the oxide film can appropriately function as a protective film, so that the silicon carbide powder can be prevented from being contaminated by impurities. Accordingly, when the silicon carbide powder of the present disclosure of the present disclosure is used in a process of manufacturing the silicon carbide ingot, the introduction of impurities can be minimized.

Accordingly, the silicon carbide powder of the present disclosure can result in the growth of a silicon carbide ingot with fewer defects.

First, a method of manufacturing a silicon carbide powder according to one embodiment includes an operation of preparing a silicon carbide raw material.

The silicon carbide raw material includes silicon carbide. The silicon carbide raw material may include α-phase silicon carbide and/or β-phase silicon carbide. In addition, the silicon carbide raw material may include a silicon carbide monocrystal and/or a silicon carbide polycrystal.

In addition, the silicon carbide raw material may further include unwanted impurities in addition to silicon carbide.

The silicon carbide raw material may further include a carbon-based material such as graphite as an impurity. The carbon-based material may be derived from a graphite crucible and the like. The carbon-based material may be included in the silicon carbide raw material in a content ranging from about 5 % by weight to about 50 % by weight. The carbon-based material may be included in a content of about 50 % by weight or less in the silicon carbide raw material. The carbon-based material may be included in a content of about 45 % by weight or less in the silicon carbide raw material. The carbon-based material may be included in a content of about 40 % by weight or less in the silicon carbide raw material. The carbon-based material may be included in a content ranging from about 1 % by weight to about 50 % by weight in the silicon carbide raw material. The carbon-based material may be included in a content ranging from about 5 % by weight to about 45 % by weight in the silicon carbide raw material. The carbon-based material may be included in a content ranging from about 10 % by weight to about 40 % by weight in the silicon carbide raw material. The carbon-based material may be included in a content ranging from about 10 % by weight to about 35 % by weight in the silicon carbide raw material. The carbon-based material may be included in a content ranging from about 10 % by weight to about 30 % by weight in the silicon carbide raw material. The carbon-based material may be included in a content ranging from about 10 % by weight to about 20 % by weight in the silicon carbide raw material.

The silicon carbide raw material may further include free silicon as an impurity. Free silicon may be derived from a silicon substrate and/or a silicon component, etc. The silicon component may be a component applied to a semiconductor equipment such as a focus ring. The free silicon may be included in a content ranging from about 0.01 % by weight to about 10 % by weight in the silicon carbide raw material.

The silicon carbide raw material may further include a metallic impurity. The metallic impurity may be at least one or more selected from the group consisting of lithium, boron, sodium, aluminum, phosphorus, potassium, calcium, titanium, vanadium, chromium, manganese, iron, nickel, copper, zinc, strontium, zirconium, molybdenum, tin, barium, tungsten, and lead.

The content of the metallic impurity may range from about 0.1 ppm to 13 ppm. The content of the metallic impurity may range from about 0.3 ppm to 12 ppm. The content of the metallic impurity may range from about 0.5 ppm to 8 ppm. The content of the metallic impurity may range from about 0.8 ppm to 10 ppm. The content of the metallic impurity may range from about 1 ppm to 6 ppm. The content of the metallic impurity may range from about 0.1 ppm to 5 ppm. The content of the metallic impurity may be about 0.5 ppm to 3 ppm. The content of the metallic impurity may range from about 0.5 ppm to 2 ppm. The silicon carbide raw material may further include a metallic impurity.

The silicon carbide raw material may further include a non-metallic impurity. The non-metallic impurity may be one or more selected from the group consisting of fluorine, nitrogen, chlorine, and phosphorus.

The content of the non-metallic impurity may range from about 0.01 ppm to 13 ppm. The content of the non-metallic impurity may range from about 0.03 ppm to 12 ppm. The content of the non-metallic impurity may range from about 0.05 ppm to 8 ppm. The content of the non-metallic impurity may range from about 0.08 ppm to 10 ppm. The content of the non-metallic impurity may range from about 0.1 ppm to 6 ppm. The content of the non-metallic impurity may range from about 0.1 ppm to 5 ppm. The content of the non-metallic impurity may range from about 0.5 ppm to 3 ppm. The content of the non-metallic impurity may range from about 0.5 ppm to 2 ppm.

The silicon carbide raw material may have a lump shape. The silicon carbide raw material may have a plate shape. The silicon carbide raw material may have a rod shape.

The silicon carbide raw material may include about 30 % by weight or more of particles having diameter of about 1 mm or more. The silicon carbide raw material may include about 50 % by weight or more of particles having diameter of about 1 mm or more. The silicon carbide raw material may include about 70 % by weight or more of particles having diameter of about 1 mm or more.

The silicon carbide raw material may include about 30 % by weight or more of particles having diameters of about 10 mm or more. The silicon carbide raw material may include about 50 % by weight or more of particles having diameter of about 10 mm or more. The silicon carbide raw material may include about 70 % by weight or more of particles having diameter of about 10 mm or more.

Here, a sphere having the same volume as the volume of the particle is assumed, and the diameter of the sphere is defined as the particle diameter.

In addition, the silicon carbide raw material may be derived from a substrate including silicon carbide. The silicon carbide raw material may be derived from a wafer entirely including silicon carbide. The silicon carbide raw material may be derived from a silicon carbide layer, deposited on a substrate, such as silicon.

In addition, the silicon carbide raw material may be derived from a silicon carbide monocrystal ingot. This silicon carbide monocrystal ingot may have beeen discarded due to defects occurring during a prior manufacturing process. Alternatively, the silicon carbide raw material may be derived from a silicon carbide polycrystal.

The silicon carbide raw material may be derived from a silicon carbide sintered body. The silicon carbide sintered body may be formed by sintering a silicon carbide powder. The silicon carbide sintered body may be a component included in semiconductor manufacturing equipment.

The silicon carbide raw material may be derived from a graphite component including a silicon carbide layer. The graphite component may include a crucible for forming a silicon carbide ingot, etc.

The silicon carbide raw material may be derived from a component of a semiconductor equipment including a silicon carbide layer. The silicon carbide layer may be formed by depositing silicon carbide on the surface on a silicon component, etc. by a chemical vapor deposition (CVD) process.

The method of manufacturing a silicon carbide powder according to another embodiment may include an operation of cutting the silicon carbide raw material.

When the silicon carbide raw material is too large, the silicon carbide raw material may be cut by a wire saw or bar cutting which includes diamond abrasive grains, etc. The silicon carbide raw material may be cut to a length of 150 mm.

The method of manufacturing a silicon carbide powder according to another embodiment may include an operation of crushing a silicon carbide raw material.

The operation of crushing a silicon carbide raw material may be a process of breaking the silicon carbide raw material into particles having an average particle diameter of about 100 mm or less. By the crushing process, the silicon carbide raw material may be split into particles having an average particle diameter of about 80 mm or less. By the crushing process, the silicon carbide raw material may be split into particles having an average particle diameter of about 60 mm or less. By the crushing process, the silicon carbide raw material may be split into particles having an average particle diameter of about 50 mm or less. By the crushing process, the silicon carbide raw material may be split into particles having an average particle diameter ranging from about 0.1 mm to about 50 mm. By the crushing process, the silicon carbide raw material may be split into particles having an average particle diameter ranging from about 1 mm to about 40 mm.

In the crushing process, a jaw crusher, a cone crusher, or a gyratory crusher may be used.

The jaw crusher includes a pair of compression plates, and the silicon carbide raw material is inserted between the compression plates. The silicon carbide raw material is crushed by the pressure applied through the compression plates, and the crushed silicon carbide raw material may be discharged downward by magnetic gravity.

Each of the compression plates may include at least one or more of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the compression plate in direct contact with the silicon carbide raw material may be coated with tungsten carbide.

The gyratory crusher includes a crushing head and a crushing bowl accommodating the crushing head. The crushing head has a truncated cone shape, and the crushing head is mounted on a shaft. An upper end of the crushing head is fixed to a flexible bearing, and a lower end of the crushing head is driven eccentrically to draw a circle. The crushing action is made around the entire cone, and the maximum movement is made at the bottom. Accordingly, since the crushing of the gyratory crusher continues to operate, the gyratory crusher has less stress fluctuation and lower power consumption than the jaw crusher.

Like the jaw crusher, the crushing head and the crushing bowl which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the crushing head and the crushing bowl which are in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the crushing head and the crushing bowl in direct contact with the silicon carbide raw material may be coated with tungsten carbide.

The cone crusher is a device for crushing the silicon carbide raw material by both an impact force and compression force. The cone crusher has a similar structure and crushing motion to the gyratory crusher. However, the cone crusher may have shorter cones. The cone crusher includes an umbrella-shaped cone mantle head mounted on a vertical central axis. By the eccentric motion of the cone mantle head, the silicon carbide raw material is compressed into a cone cave bowl, and as it goes down, the silicon carbide raw material is crushed.

Like the jaw crusher, the cone mantle head and the cone cave bowl whish are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the cone mantle head and the cone cave bowl in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portion of the cone mantle head and the cone cave bowl in direct contact with the silicon carbide raw material may be coated with the tungsten carbide.

The method of manufacturing a silicon carbide powder according to another embodiment may include an operation of pulverizing a silicon carbide raw material.

The operation of pulverizing a silicon carbide raw material may include a process of breaking the silicon carbide raw material into particles having a diameter of about 30 mm or less. By the pulverization process, the silicon carbide raw material may be split into particles having an average particle diameter of about 20 mm or less. By the pulverization process, the silicon carbide raw material may be split into particles having an average particle diameter of about 15 mm or less. By the pulverization process, the silicon carbide raw material may be split into particles having an average particle diameter of about 10 mm or less. By the pulverization process, the silicon carbide raw material may be split into particles having an average particle diameter ranging from about 0.1 mm to about 10 mm. By the pulverization process, the silicon carbide raw material may be split into particles having an average particle diameter ranging from about 0.1 mm to about 8 mm. By the pulverization process, the silicon carbide raw material may be split into particles having an average particle diameter ranging from about 0.01 mm to about 6 mm.

In the pulverization process, a ball mill, a hammer crusher, a jet mill, or the like may be used.

The ball mill may include a metal cylinder and a ball. The ball and the silicon carbide raw material are placed in the metal cylinder. When the metal cylinder rotates, the ball and the silicon carbide raw material can be rotated by the friction between the ball and the silicon carbide raw material and the centrifugal force within the metal cylinder. At this time, the ball and the silicon carbide raw material rise to a certain height in the cylinder, and then fall, and the silicon carbide raw material is pulverized and polished. Depending on the rotational speed of the cylinder, the inner diameter of the cylinder, the size of the ball, the material of the ball, and the time of the pulverization process, the silicon carbide raw material may be split into particles having a small diameter.

The metal cylinder and the ball which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portion of the metal cylinder and the ball in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the metal cylinder and the ball in direct contact with the silicon carbide raw material may be coated with tungsten carbide.

The hammer crusher includes a chamber and multiple hammers. The hammers are mounted on a rotating body placed within the chamber. The hammers rotate within the chamber, and the hammers impact on the silicon carbide raw material. Accordingly, the silicon carbide raw material may be split into particles having a small diameter.

The chamber and the hammers which are parts in direct contact with the silicon carbide raw material may include at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be made of at least one or more of steel, stainless steel, manganese-added steel, chromium-added steel, nickel-added steel, molybdenum-added steel, nitrogen-added steel, and tungsten carbide. Portions of the chamber and the hammers in direct contact with the silicon carbide raw material may be coated with tungsten carbide.

The jet mill pulverizes the silicon carbide raw material by mutually colliding the silicon carbide raw materials with each other under the energy of injection from the nozzle by the pressure of a fluid. The silicon carbide raw material is pulverized in the chamber until the particle size thereof reaches a desired size. In addition, the particles subjected to the pulverization process are collected through a classification chamber from the jet mill chamber. Since the jet mill pulverizes the silicon carbide raw material by mutual collision of the silicon carbide raw material by the pressure of fluid, the contamination of the silicon carbide raw material by direct contact with other non-silicon carbide devices may be minimized.

The chamber which is a part in direct contact with the silicon carbide raw material may include at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be made of at least one or more of steel, stainless steel, manganese-added steel, chromium-added steel, nickel-added steel, molybdenum-added steel, nitrogen-added steel, and tungsten carbide. A portion of the chamber which is in direct contact with the silicon carbide raw material may be coated with tungsten carbide.

The method of manufacturing a silicon carbide powder according to another embodiment may further include an operation of removing iron by application of a magnetic force.

The operation of removing an iron component may be an operation of removing iron adsorbed to the silicon carbide raw material in the crushing and pulverizing operations.

In the operation of removing an iron component, a rotary metal detector may be used to remove the iron.

A rotation speed of the rotary metal detector may be about 100 rpm to about 800 rpm, and an output of an electromagnet included in the rotary metal detector may be about 0.5 kW to about 3 kW. In addition, a rotation speed of the rotary metal detector may be about 800 rpm to about 1700 rpm, and an output of an electromagnet included in the rotary metal detector may be about 3 kW to about 5 kW.

The content of iron contained in the silicon carbide raw material from which iron has been removed may be about 1 ppm or less. The content of iron contained in the silicon carbide raw material from which iron has been removed about 0.5 ppm or less. The content of iron contained in the silicon carbide raw material from which iron has been removed about 0.3 ppm or less. The content of iron contained in the silicon carbide raw material from which iron has been removed about 0.1 ppm or less.

The method of manufacturing a silicon carbide powder according to another embodiment includes an operation of removing the carbon-based material.

The operation of removing the carbon-based material may include an operation of physically removing the carbon-based material.

The operation of physically removing the carbon-based material may include a steel cut wire shot process. A wire used for the steel cut wire shot may be made of carbon steel, stainless steel, aluminum, zinc, nickel, copper, or an alloy thereof, but is not limited thereto. In addition, the diameter of the wire may range from about 0.2 mm to about 0.8 mm. The diameter of the wire may range from about 0.4 mm to about 0.6 mm.

A rotation speed of the wire may range from about 1000 rpm to about 5000 rpm.

In addition, the operation of physically removing the carbon-based material may include a blasting process such as sand blasting or short blasting. The blasting process may be a process of spraying fine particles on the carbon-based material such as graphite to remove the carbon-based material. That is, since the carbon-based material has a lower hardness than the silicon carbide, it can be removed by fine particles sprayed with an appropriate pressure.

In addition, the operation of physically removing the carbon-based material may include a separation process using the density difference and usingcentrifugation. The crushed and/or pulverized silicon carbide raw material may be separated by a density difference between the carbon-based material and the silicon carbide. That is, since the density of silicon carbide is larger than the density of graphite, the carbon-based material may be removed by a density gradient centrifugation, etc.

After the operation of physically removing the carbon-based material, the content of the carbon-based material included in the raw material may be about 5 % by weight or less. After the operation of removing the carbon-based material, the content of the carbon-based material included in the raw material may be about 3 % by weight or less. After the operation of removing the carbon-based material, the content of the carbon-based material included in the raw material may be about 1 % by weight or less.

In addition, the operation of removing the carbon-based material includes an operation of chemically removing the carbon-based material.

The operation of chemically removing the carbon-based material includes an operation of oxidizing the carbon-based material.

After the carbon-based material contained in the raw material is sufficiently removed, the raw material is heat-treated in an oxygen or atmospheric atmosphere. At this time, the oxidative heat treatment temperature may range from about 1000 °C to about 1200 °C. The heat treatment time may range from about 12 hours to about 48 hours.

Since the raw material is heat-treated in the above time and temperature ranges, the carbon-based material contained in the raw material may be effectively removed. In addition, since the raw material is heat-treated in the above time and temperature ranges, the generation of by-products such as silicon oxide in the raw material may be minimized.

The method of manufacturing a silicon carbide powder according to another embodiment includes an operation of classifying the silicon carbide raw material. In the classifying operation, the silicon carbide raw material granulated through the crushing process and the pulverizing process may be classified.

The granulated silicon carbide raw material may be classified by a mesh of a desired size.

The classifying operation may be performed using a twist screen that is a vibrating classifying device.

The twist screen may include a silicon material-made tapping ball having a diameter ranging from 10 mm to 80 mm, 15 mm to 70 mm, or 20 mm to 60 mm. Using the twist screen, the classifying operation may be performed for about 10 minutes to about 100 minutes under a vibration condition ranging from about 1000 times/minute to about 3000 times/minute.

The granulated silicon carbide raw material may be fed into the twist screen at a constant speed.

The particle diameter (D50) of the granulated silicon carbide raw material may be about 10 µm to about 10000 µm. The particle diameter (D50) of the granulated silicon carbide raw material may be about 100 µm to about 6000 µm. The particle diameter (D50) of the granulated silicon carbide raw material may be about 60 µm to about 5000 µm. The particle diameter (D50) of the granulated silicon carbide raw material may be about 100 µm to about 4000 µm. The particle diameter (D50) of the granulated silicon carbide raw material may be about 150 µm to about 400 µm. The particle diameter (D50) of the granulated silicon carbide raw material may be about 300 µm to about 800 µm. The particle diameter (D50) of the granulated silicon carbide raw material may be about 500 µm to about 1000 µm. The particle diameter (D50) of the granulated silicon carbide raw material may be about 700 µm to about 2000 µm. The particle diameter (D50) of the granulated silicon carbide raw material may be about 1000 µm to about 3000 µm.

The silicon carbide powder according to the embodiment includes an operation of processing the surface of a granulated silicon carbide raw material.

The operation of processing the surface of the granulated silicon carbide raw material may include an operation of wet-etching the silicon carbide raw material.

The wet-etching operation is performed using an etchant. The silicon carbide raw material that has been subjected to the crushing and pulverization processes may be subjected to the wet-etching operation.

The etchant may include water and acid. The acid included in the etchant may be at least one selected from the group consisting of hydrofluoric acid, nitric acid, hydrochloric acid, and sulfuric acid.

The etchant may include water, hydrofluoric acid, and nitric acid.

The hydrofluoric acid may be included in a content ranging from about 5 parts by weight to about 40 parts by weight based on 100 parts by weight of the water in the etchant. The hydrofluoric acid may be included in a content ranging from about 10 parts by weight to about 35 parts by weight based on 100 parts by weight of the water in the etchant. The hydrofluoric acid may be included in a content ranging from about 12.5 parts by weight to about 30 parts by weight based on 100 parts by weight of the water in the etchant.

The nitric acid may be included in a content ranging from about 3 parts by weight to about 30 parts by weight based on 100 parts by weight of the water in the etchant. The nitric acid may be included in a content ranging from about 4 parts by weight to about 25 parts by weight based on 100 parts by weight of the water in the etchant. The nitric acid may be included in a content ranging from about 5 parts by weight to about 20 parts by weight based on 100 parts by weight of the water in the etchant.

The etchant may be filled in an etching vessel. Here, the etchant may be filled in an amount ranging from about 10 vol% to about 20 vol% based on the total volume of the etching vessel in the etching vessel. The etchant may be filled in an amount ranging from about 12 vol% to about 18 vol% based on the total volume of the etching vessel in the etching vessel. In addition, the silicon carbide raw material may be filled in an amount ranging from about 10 vol% to about 30 vol% based on the total volume of the etching vessel in the etching vessel. The silicon carbide raw material may be filled in an amount ranging from about 15 vol% to about 25 vol% based on the total volume of the etching vessel in the etching vessel. When the silicon carbide raw material is filled in the etching vessel, the volume of the silicon carbide raw material may be measured as an apparent volume.

The silicon carbide raw material may be wet-etched by the etchant. That is, the surface of the silicon carbide raw material may be etched by the etchant, and impurities remaining on the surface of the silicon carbide raw material may be removed by the etchant.

The wet etching operation may be carried out according to the following processes.

First, the etching vessel and the silicon carbide raw material may be dried. The etching vessel and the silicon carbide raw material may be dried with hot air at about 50 °C to about 150 °C for about 10 minutes to about 1 hour.

Next, the silicon carbide raw material is placed in the etching vessel.

Next, the etchant is fed into the etching vessel in which the silicon carbide raw material has been placed.

A process of feeding the etchant may be as follows.

First, deionized water is fed into the etching vessel in which the silicon carbide raw material has been placed.

Next, hydrofluoric acid is fed into the etching vessel into which the deionized water has been fed.

Next, nitric acid is fed into the etching vessel into which the hydrofluoric acid has been fed.

Next, the etching vessel into which the etchant has been fed is sealed by a lid, the silicon carbide raw material and etchant contained in the etching vessel are stirred at a speed ranging from about 50 rpm to about 500 rpm. The stirring time may be about 30 minutes to about 2 hours.

Next, the etchant is drained, and the silicon carbide raw material subjected to the wet etching process is precipitated several times in deionized water and neutralized. At this time, after precipitation, the neutralization process of the silicon carbide raw material that has undergone the wet etching process may be completed based on the content and/or pH of hydrofluoric acid contained in the drained wastewater. When the pH of the wastewater is 6.8 to 7.2, the neutralization process may be finished.

The operation of processing the surface of the granulated silicon carbide raw material may include an operation of dry-etching the silicon carbide raw material.

The dry etching process may be performed by spraying an etching gas onto the silicon carbide raw material.

The etching gas may include a chlorine gas. The etching gas may further include an inert gas such as argon as a carrier gas.

The dry etching process may be carried out as follows.

First, a dry etching furnace is prepared. The dry etching furnace may be made of graphite and may be heated to a temperature ranging from about 2000 °C or more. The dry etching furnace is sealed against the outside, and the inside of the dry etching furnace may be depressurized up to about 5 Torr or less.

The silicon carbide raw material is placed in the dry etching furnace.

Next, the dry etching furnace is heated up to a temperature ranging from about 1800 °C to about 2200 °C.

Next, the inside of the dry etching furnace is depressurized to a pressure ranging from about 1 Torr to about 30 Torr. The inside of the dry etching furnace is depressurized to a pressure ranging from about 1 Torr to about 10 Torr. The inside of the dry etching furnace is depressurized to a pressure ranging from about 1 Torr to about 8 Torr.

Next, the etching gas is fed into the dry etching furnace. The etching gas may be convected in the dry etching furnace by a temperature difference between the lower portion and the upper portion of the dry etching furnace. That is, the temperature of the lower portion of the dry etching furnace ranges from about 50 °C to about 100 °C higher than the temperature of the upper portion of the dry etching furnace, so that the etching gas at the lower portion of the dry etching furnace moves to the upper portion of the dry etching furnace, thereby dry etching the surface of the silicon carbide raw material. The residence time of the etching gas in the dry etching furnace may be about 24 hours to about 96 hours.

Next, the etching gas may be removed by a wet scrubber, and the pressure of the inside of the dry etching furnace may be increased to about 600 Torr to about 780 Torr.

The operation of processing the surface of the granulated silicon carbide raw material may include a heat treatment process.

The dry-etched silicon carbide particles may be heat-treated at a temperature ranging from about 700 °C to about 1300 °C in an atmosphere containing oxygen in the dry etching furnace. The dry-etched silicon carbide particles may be heat-treated at about a temperature ranging from 800 °C to about 1200 °C in an atmosphere containing oxygen in the dry etching furnace. The dry-etched silicon carbide particles may be heat-treated at a temperature ranging from about 900 °C to about 1100 °C in an atmosphere containing oxygen in the dry etching furnace. The heat treatment time may range from about 10 minutes to about 2 hours. The heat treatment time may range from about 20 minutes to about 1 hour.

By the heat treatment, chlorine remaining on the surface of the dry-etched silicon carbide particles may be removed.

The operation of processing the surface of the granulated silicon carbide raw material may include a process of adjusting the thickness of an oxide film.

The process of adjusting the thickness of an oxide film may be performed by a wet process.

The silicon carbide raw material is fed into an etching container, and a surface treatment liquid is fed into the etching container.

The surface treatment liquid includes deionized water, an acid and an oxidizing agent.

The acid included in the surface treatment liquid may be at least one or more selected from the group consisting of citric acid, hydrofluoric acid, nitric acid, hydrochloric acid and sulfuric acid.

The acid included in the surface treatment liquid may be citric acid.

The oxidizing agent may be at least one or more selected from the group consisting of hydrogen peroxide and ozone.

The oxidizing agent may be hydrogen peroxide.

The surface treatment liquid may include the acid in a content ranging from about 0.5 parts by weight to about 10 parts by weight based on 100 parts by weight of the deionized water. The surface treatment liquid may include the acid in a content ranging from about 0.7 parts by weight to about 5 parts by weight based on 100 parts by weight of the deionized water. The surface treatment liquid may include the acid in a content ranging from about 1 part by weight to about 3 parts by weight based on 100 parts by weight of the deionized water.

T\e surface treatment liquid may include the oxidizing agent in a content ranging from about 0.5 parts by weight to about 10 parts by weight based on 100 parts by weight of the deionized water. The surface treatment liquid may include the oxidizing agent in a content ranging from about 0.7 parts by weight to about 7 parts by weight based on 100 parts by weight of the deionized water. The surface treatment liquid may include the oxidizing agent in a content ranging from about 1 part by weight to about 5 parts by weight based on 100 parts by weight of the deionized water.

Next, the silicon carbide raw material and surface treatment liquid in the etching container are stirred, and the thickness of the oxide film on the surface of the silicon carbide raw material may be adjusted.

In the process of adjusting the thickness of an oxide film, the stirring process may be performed for about 10 minutes to about 60 minutes. In the process of adjusting the thickness of an oxide film, the stirring process may be performed for about 10 minutes to about 30 minutes.

Since the surface treatment liquid contains both an acid and an oxidizing agent, the surface treatment liquid may etch the oxide film and form the oxide film at the same time. Accordingly, the surface treatment liquid may treat the surface of the silicon carbide raw material so that the oxide film has an appropriate thickness.

The silicon carbide raw material whose oxide film thickness has been adjusted is neutralized with deionized water.

The method of manufacturing a silicon carbide powder according to another embodiment may include an operation of washing the silicon carbide raw material.

The washing process may be carried out using a washing solution including at least one selected from the group consisting of hydrofluoric acid, distilled water, and ultrapure water.

The washing process may include a first washing operation, a first hydrofluoric acid treatment operation, a second washing operation, a second hydrofluoric acid treatment operation, and a third washing operation.

The first washing operation may be performed for 1 minute to 300 minutes using distilled water, ultrapure water, or pure water. For example, the first washing operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the first hydrofluoric acid treatment operation is an operation of washing the silicon carbide raw material using a washing solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes or about 20 minutes to about 40 minutes in the washing solution. Next, the silicon carbide raw material may be precipitated in the washing solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the washing solution.

The second washing operation may be performed for 1 minute to 300 minutes using distilled water, ultrapure water, or pure water. For example, the second washing operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

Next, the second hydrofluoric acid treatment operation is an operation of washing the silicon carbide raw material using a washing solution including hydrofluoric acid. The silicon carbide raw material may be stirred for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the washing solution. Next, the silicon carbide raw material may be precipitated in the washing solution. The silicon carbide raw material may be precipitated for about 1 minute to about 300 minutes, about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes in the washing solution.

The third washing operation may be performed for 1 minute to 300 minutes using distilled water, ultrapure water, or pure water. For example, the third washing operation may be performed for about 1 minute to about 250 minutes, about 1 minute to about 200 minutes, about 3 minutes to about 150 minutes, about 10 minutes to about 100 minutes, about 15 minutes to about 80 minutes, about 20 minutes to about 60 minutes, or about 20 minutes to about 40 minutes.

By the graphite removal process, the iron component removal process, the wet-etching process, the dry-etching process, and the washing process, the silicon carbide powder according to the embodiment may have a very high purity.

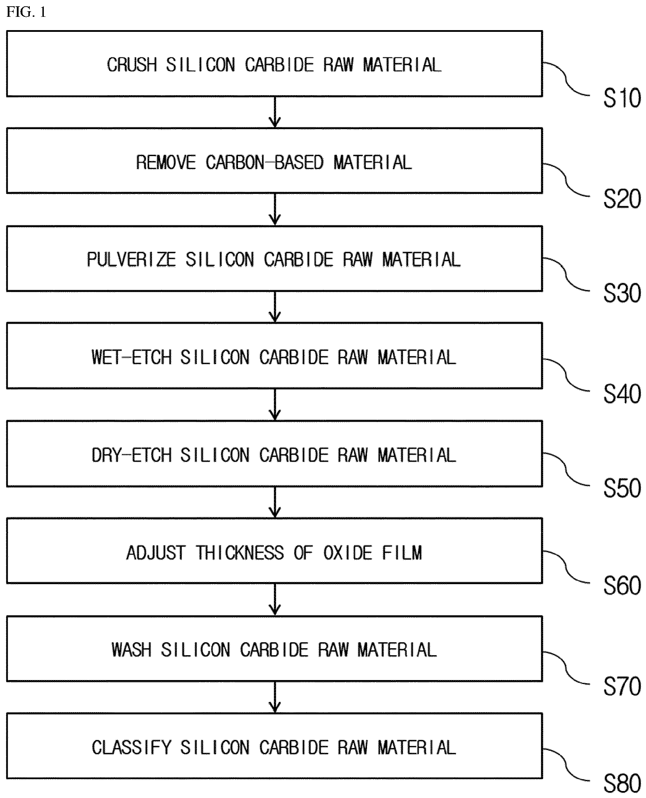

Referring to FIG. 1, a silicon carbide powder according to another embodiment may be prepared by the following process.

First, the silicon carbide raw material is crushed in the crushing process (S10).

Next, a carbon-based material such as graphite included in the silicon carbide raw material is removed by the carbon-based material removal process (S20).

Next, a silicon carbide raw material from which the carbon-based material has been removed is pulverized by the pulverization process (S30).

Next, the pulverized silicon carbide raw material is etched by the wet-etching process (S40). Accordingly, impurities attached to the surface of the pulverized silicon carbide raw material may be removed. In particular, a carbon-based material remaining in the pulverized silicon carbide raw material may suspend in the etchant with hydrofluoric acid, etc. contained in the etchant. Accordingly, in the wet-etching process, the carbon-based material as well as metal impurities may be efficiently removed.

Next, the wet-etched silicon carbide raw material is etched by a dry-etching process (S50).

Next, the thickness of an oxide film disposed on the surface of the dry-etched silicon carbide raw material is adjusted (S60).

Next, the silicon carbide raw material whose oxide film thickness has been adjected is subjected to a washing process (S70).

Next, the washed silicon carbide raw material may be classified into a desired particle size (S80).

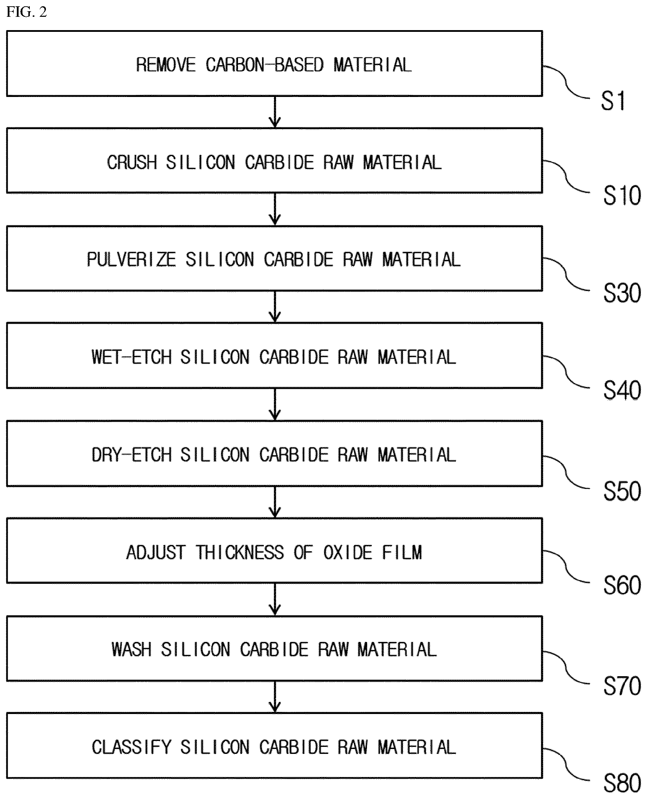

Referring to FIG. 2, the silicon carbide powder according to another embodiment may be prepared by the following process.

In this embodiment, a carbon-based material removal process (S1) is substantially the same as the process of FIG. 1, but may be performed before the crushing process.

When the silicon carbide raw material contains appreciable carbon as impurities, the carbon-based material removal process may precede. For example, when the silicon carbide raw material contains a high percentage of graphite components such as graphite components coated with silicon carbide, the carbon-based material removal process may be performed in advance.

Since the carbon-based material is removed in advance (S1) and is subjected to the crushing process (S10), a carbon-based material contained in the silicon carbide raw material may be efficiently removed.

Accordingly, the method of manufacturing the silicon carbide powder according to this embodiment may provide a high-purity silicon carbide powder by using a silicon carbide raw material containing a high content of carbon-based material.

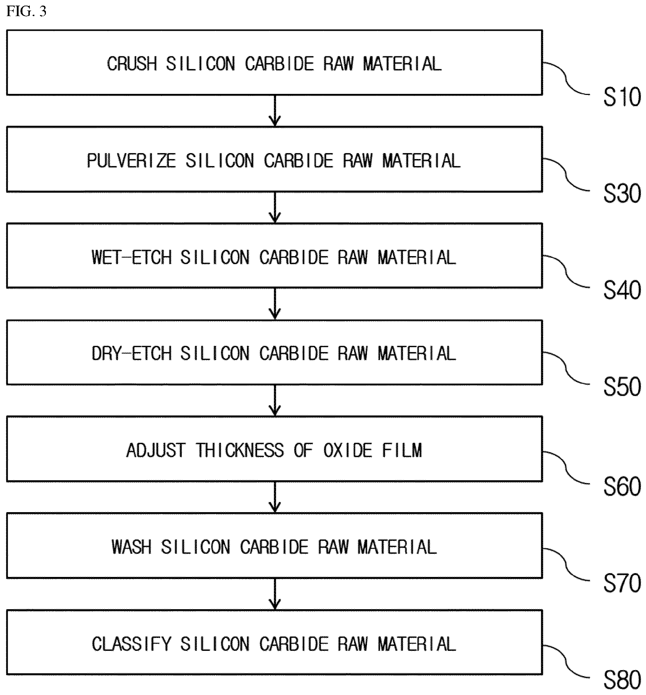

Referring to FIG. 3, the method of manufacturing the silicon carbide powder according to another embodiment may be prepared by the following process.

This embodiment may be substantially the same as the process of FIG. 1, but the carbon-based material removal process may be omitted.

When the silicon carbide raw material does not include a carbon-based material such as the graphite or includes it in a very low content, the carbon-based material removal process may be omitted. For example, the silicon carbide raw material may include about 95 % by weight or more of silicon carbide as in a monocrystalline silicon carbide ingot, a polycrystalline silicon carbide or a silicon carbide sintered body. In this case, a small amount of carbon-based material may be removed in the wet-etching process, etc., so that a high-purity silicon carbide powder may be obtained even without an additional process.

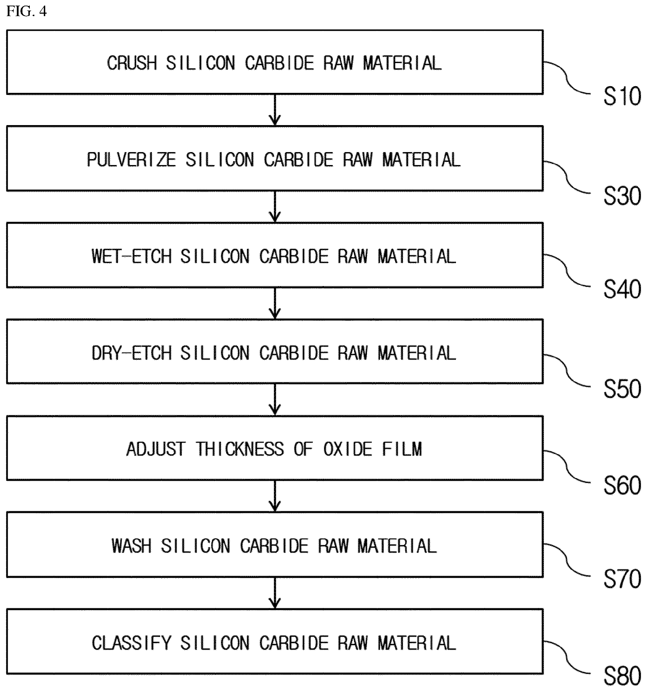

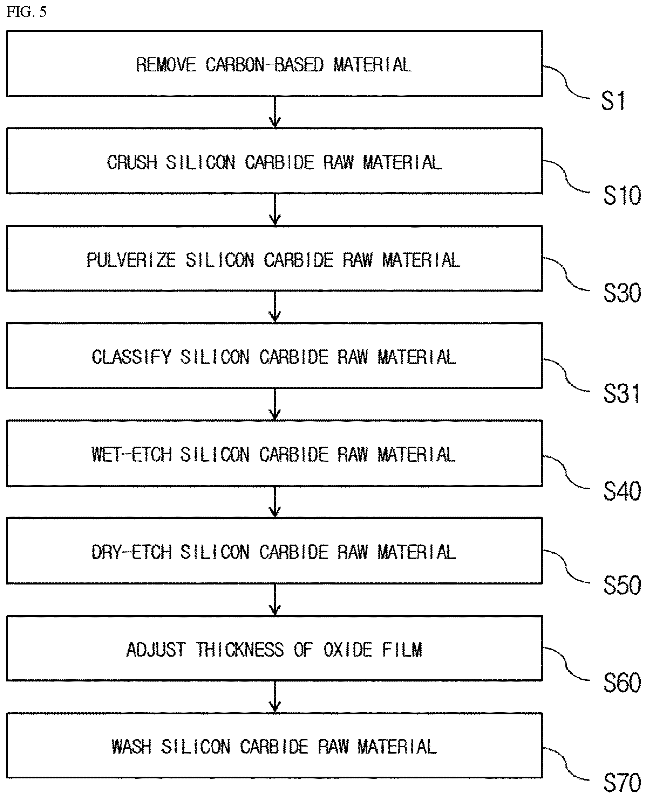

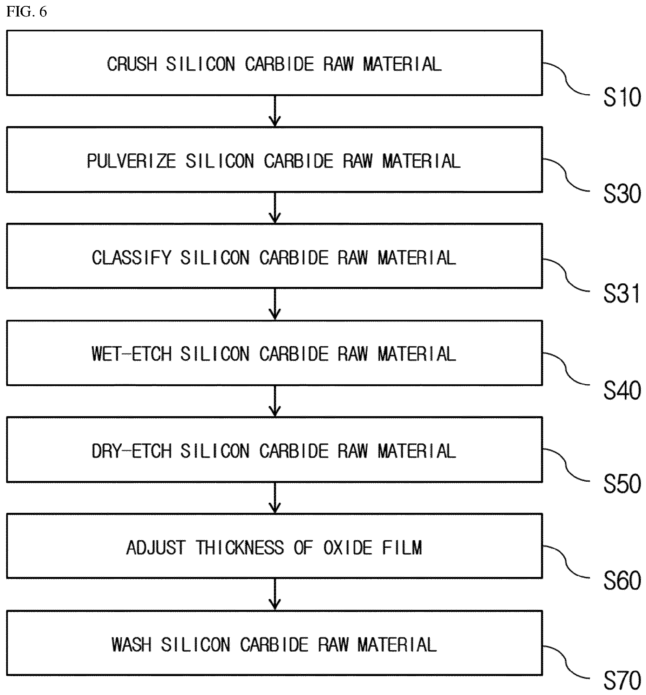

Referring to FIGS. 4 to 6, the silicon carbide powder according to other embodiments may be prepared by the following process.

These embodiment may be substantially the same as the process of FIG. 1, 2 or 3, but as shown in FIGs. 4, 5, and 6, the classification process (S31) may be performed immediately after the pulverization process (S30). That is, the pulverized silicon carbide raw material may be classified (divided up) into a desired particle size through the classification process immediately after the pulverization process. Furthermore, the classified silicon carbide raw material may be subjected to the wet-etching process, the dry-etching process and the washing process. The classified silicon carbide raw material may be subjected to the wet etching process, the dry-etching process, the oxide film thickness adjustment process and the washing process.

In these embodiments in FIGs. 4, 5, and 6, since the silicon carbide raw material is classified (by particle size) into a uniform particle size, and then subjected to the wet-etching process and the dry-etching process, the surface of the silicon carbide raw material may be uniformly etched as a whole. In particular, since the silicon carbide raw material is classified into a uniform particle size, spaces between particles of the silicon carbide raw material may be uniformly formed. Accordingly, the etching gas may uniformly permeate into the spaces between the silicon carbide raw material, and the dry-etching process may uniformly etch the silicon carbide raw materials as a whole.

Accordingly, the method of manufacturing the silicon carbide powder according to these embodiments may uniformly control the contents of carbon, silicon and oxygen included in the surface as a whole.

A purity of the silicon carbide powder obtained by the processes in FIGs. 1-4 according to one embodiment may be about 99.99% or more. The purity of the silicon carbide powder according to another embodiment may be about 99.999% or more. The purity of the silicon carbide powder according to another embodiment may be about 99.9999% or more. The purity of the silicon carbide powder according to another embodiment may be about 99.999999% or more. The purity of the silicon carbide powder according to another embodiment may be about 99.9999999% or more. The purity of the silicon carbide powder according to another embodiment may be about 99.9999999% or more. The purity of the silicon carbide powder according to another embodiment may be about 99.99999999% or more.

The silicon carbide powder according to another embodiment may include one or more impurities selected from the group consisting of lithium, sodium, magnesium, aluminum, potassium, calcium, titanium, vanadium, chromium, manganese, iron, cobalt, nickel, copper, zinc and molybdenum in a content ranging from about 1 ppm or less, about 0.8 ppm or less, about 0.7 ppm or less, about 0.1 to about 0.7 ppm or about 0.1 to about 0.6 ppm.

In addition, a particle diameter (D50) of the silicon carbide powder according to one embodiment may range from about 10 µm to about 10000 µm. The particle diameter (D50) of the silicon carbide powder according to the embodiment may range from about 100 µm to about 6000 µm. The particle diameter (D50) of the silicon carbide powder according to the embodiment may range from about 60 µm to about 5000 µm. The particle diameter (D50) of the silicon carbide powder according to the embodiment may range from about 100 µm to about 4000 µm. The particle diameter (D50) of the silicon carbide powder according to the embodiment may range from about 150 µm to about 400 µm. The particle diameter (D50) of the silicon carbide powder according to the embodiment may range from about 300 µm to about 800 µm. The particle diameter (D50) of the silicon carbide powder according to the embodiment may range from about 500 µm to about 1000 µm. The particle diameter (D50) of the silicon carbide powder according to the embodiment may range from about 700 µm to about 2000 µm. The particle diameter (D50) of the silicon carbide powder according to the embodiment may range from about 1000 µm to about 3000 µm.

An oxygen element may be included in an appropriate content in the surface of the silicon carbide powder according to another embodiment.

The content of oxygen included in the surface of the silicon carbide powder according to one embodiment may range from about 3 atom% to about 23 atom%. The content of oxygen included in the surface of the silicon carbide powder according to another embodiment may range from about 4 atom% to about 20 atom%. The content of oxygen included in the surface of the silicon carbide powder according to another embodiment may range from about 4 atom% to about 18 atom%. The content of oxygen included in the surface of the silicon carbide powder according to another embodiment may range from about 4 atom% to about 15 atom%. The content of oxygen included in the surface of the silicon carbide powder according to another embodiment may range from about 4 atom% to about 13 atom%. The content of oxygen included in the surface of the silicon carbide powder according to another embodiment may range from about 4 atom% to about 11 atom%. The content of oxygen included in the surface of the silicon carbide powder according to another embodiment may range from about 5 atom% to about 10 atom%.

The content of oxygen included in the surface of the silicon carbide powder may be measured by X-ray photoelectron spectroscopy.

In the X-ray photoelectron spectroscopy, the X-ray source may be monochromated Al X-Ray sources, and the Al Kα line may be about 1300 eV to about 1600 eV.

In addition, in the X-ray photoelectron spectroscopy, the X-ray power may have a voltage ranging from about 10kV to about 14kV and a current ranging from about 8mA to about 12mA.

In addition, in the X-ray photoelectron spectroscopy, the diameter of a sampling area may range from about 300 µm to about 500 µm. In the X-ray photoelectron spectroscopy, a pass energy in a narrow scan may range from about 30eV to about 50eV. In the X-ray photoelectron spectroscopy, an operation size in the narrow scan may be about 0.03eV to about 0.07eV. In addition, in the X-ray photoelectron spectroscopy, a pressure may range from about 10⁻⁹ mbar to 5×10⁻⁹ mbar. In addition, in the X-ray photoelectron spectroscopy, an etching condition may be argon ion etching with argon ion beam haing an energy ranging from about 1 keV to about 3 keV and a raster size ranging from about 1 mm×1 mm to about 3 mm×3 mm.

In the silicon carbide powder according to another embodiment, an element ratio in the surface may be measured by the X-ray photoelectron spectroscopy. For example, by the X-ray photoelectron spectroscopy, a survey spectrum or a multiplex spectrum may be obtained. A peak area of each element is derived from the survey spectrum or the multiplex spectrum through integration. A value obtained by dividing the peak area of an element by the sensitivity of each element may be a relative amount of each element. Accordingly, the ratio of each element may be obtained.

In the silicon carbide powder according to one embodiment, O1s/C1s (representing the respective peak areas of O1s and C1s peaks) of the surface measured by the X-ray photoelectron spectroscopy may be about 0.29 or less. In the silicon carbide powder according to another embodiment, O1s/C1s of the surface measured by the X-ray photoelectron spectroscopy may be about 0.28 or less. In the silicon carbide powder according to another embodiment, O1s/C1s of the surface measured by the X-ray photoelectron spectroscopy may be about 0.27 or less. In the silicon carbide powder according to another embodiment, O1s/C1s of the surface measured by the X-ray photoelectron spectroscopy may be about 0.26 or less. In the silicon carbide powder according to another embodiment, O1s/C1s of the surface measured by the X-ray photoelectron spectroscopy may be about 0.25 or less. In the silicon carbide powder according to another embodiment, O1s/C1s of the surface measured by the X-ray photoelectron spectroscopy may be about 0.24 or less. In the silicon carbide powder according to another embodiment, a minimum value of O1s/C1s of the surface measured by the X-ray photoelectron spectroscopy may be about 0.05.

In addition, in the silicon carbide powder according to another embodiment, O1s/C1s of the surface measured by the X-ray photoelectron spectroscopy may range from about 0.05 to about 0.29. In the silicon carbide powder according to another embodiment, O1s/C1s of the surface measured by the X-ray photoelectron spectroscopy may range from about 0.05 to about 0.28. In the silicon carbide powder according to another embodiment, O1s/C1s of the surface measured by the X-ray photoelectron spectroscopy may range from about 0.07 to about 0.27. In the silicon carbide powder according to another embodiment, O1s/C1s of the surface measured by the X-ray photoelectron spectroscopy may range from about 0.1 to about 0.26. In the silicon carbide powder according to another embodiment, O1s/C1s of the surface measured by the X-ray photoelectron spectroscopy may range from about 0.13 to about 0.25. In the silicon carbide powder according to another embodiment, O1s/C1s of the surface measured by the X-ray photoelectron spectroscopy may range from about 0.15 to about 0.24.

In the silicon carbide powder according to an embodiment, O1s/Si2p (representing the respective peak areas of O1s and Si2p peaks) of the surface measured by the X-ray photoelectron spectroscopy may be about 0.39 or less. In the silicon carbide powder according to another embodiment, O1s/Si2p of the surface measured by the X-ray photoelectron spectroscopy may be about 0.38 or less. In the silicon carbide powder according to another embodiment, O1s/Si2p of the surface measured by the X-ray photoelectron spectroscopy may be about 0.37 or less. In the silicon carbide powder according to another embodiment, O1s/Si2p of the surface measured by the X-ray photoelectron spectroscopy may be about 0.36 or less. In the silicon carbide powder according to another embodiment, O1s/Si2p of the surface measured by the X-ray photoelectron spectroscopy may be about 0.32 or less. A minimum value of O1s/Si2p of the surface measured by the X-ray photoelectron spectroscopy may be about 0.05.

In addition, in the silicon carbide powder according to another embodiment, O1s/Si2p of the surface measured by the X-ray photoelectron spectroscopy may range from about 0.05 to about 0.39. In the silicon carbide powder according to another embodiment, O1s/Si2p of the surface measured by the X-ray photoelectron spectroscopy may range from about 0.05 to about 0.38. In the silicon carbide powder according to another embodiment, O1s/Si2p of the surface measured by the X-ray photoelectron spectroscopy may range from about 0.1 to about 0.37. In the silicon carbide powder according to another embodiment, O1s/Si2p of the surface measured by the X-ray photoelectron spectroscopy may range from about 0.1 to about 0.36. In the silicon carbide powder according to another embodiment, O1s/Si2p of the surface measured by the X-ray photoelectron spectroscopy may range from about 0.15 to about 0.32.

In the silicon carbide powder according to another embodiment, O1s/Si2p of the surface measured by the X-ray photoelectron spectroscopy may be about 0.4 or less. In the silicon carbide powder according to another embodiment, O1s/Si2p of the surface measured by the X-ray photoelectron spectroscopy may be about 0.37 or less. In the silicon carbide powder according to another embodiment, O1s/Si2p of the surface measured by the X-ray photoelectron spectroscopy may be about 0.37 or less. In the silicon carbide powder according to another embodiment, O1s/Si2p of the surface measured by the X-ray photoelectron spectroscopy may be about 0.35 or less. In the silicon carbide powder according to another embodiment, O1s/Si2p of the surface measured by the X-ray photoelectron spectroscopy may be about 0.33 or less. In the silicon carbide powder according to another embodiment, a minimum value of O1s/Si2p of the surface measured by the X-ray photoelectron spectroscopy may be about 0.05.

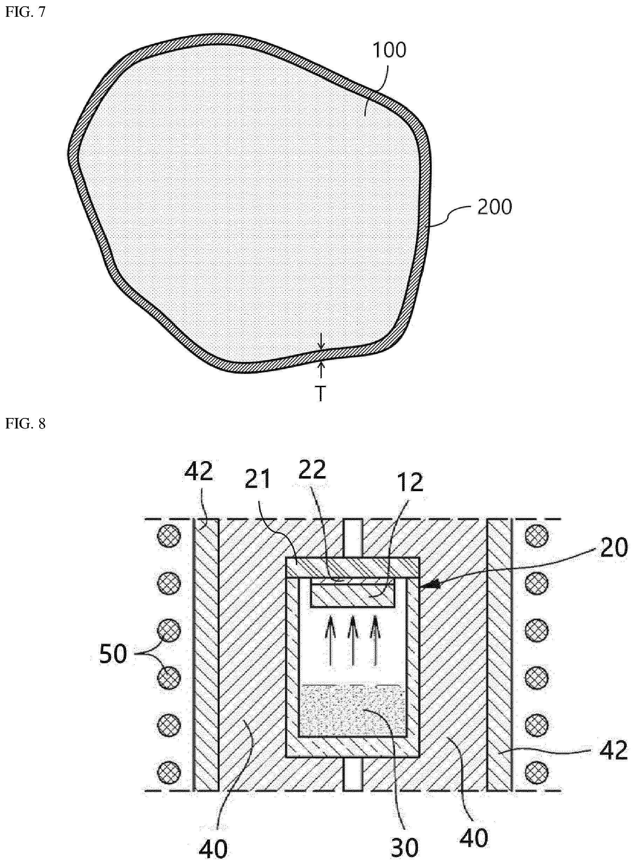

As shown in FIG. 7, the silicon carbide powder according to one embodiment includes a silicon carbide core 100 and an oxide film 200 having a thickness T.

The silicon carbide core includes silicon carbide as a main component. The silicon carbide core may include the silicon carbide in a content of 99.99 wt% or more. The silicon carbide core may be formed of substantially silicon carbide.

The oxide film is disposed around the silicon carbide core. The oxide film surrounds the silicon carbide core. The oxide film may adhere to the surface of the silicon carbide core. The oxide film may be entirely disposed on the surface of the silicon carbide core. The oxide film may cover the entire surface of the silicon carbide core, as illustrated in FIG. 7.

The thickness of the oxide film may range from about 0.1 nm to about 10 nm. The thickness of the oxide film may range from about 0.5 nm to about 8 nm. The thickness of the oxide film may range from about 0.7 nm to about 6 nm. The thickness of the oxide film may range from about 1 nm to about 6 nm. The thickness of the oxide film may range from about 0.1 nm to about 3 nm.

In the silicon carbide powder according to one embodiment, a ratio of the average particle diameter (D50) to the thickness of the oxide film may range from about 1:1×10⁻⁷ to about 1:50×10⁻⁵. In the silicon carbide powder according to the embodiment, the thickness of the oxide film relative to the average particle diameter (D50) may be about 5×10⁻⁷ to about 5×10⁻⁵. In the silicon carbide powder according to the embodiment, the thickness of the oxide film relative to the average particle diameter (D50) may be about 1×10⁻⁶ to about 50×10⁻⁶. The thickness of the oxide film relative to the average particle diameter (D50) may be about 1×10⁻⁶ to about 40×10⁻⁶. The thickness of the oxide film relative to the average particle diameter (D50) may be about 1×10⁻⁶ to about 20×10⁻⁶. The thickness of the oxide film relative to the average particle diameter (D50) may be about 1×10⁻⁶ to about 10×10⁻⁶. The thickness of the oxide film relative to the average particle diameter (D50) may be about 1×10⁻⁶ to about 5×10⁻⁶.

The silicon carbide powder according to the embodiment satisfies the above ratios of the average particle diameter (D50) to the thickness of the oxide film. In particular, the surface of the silicon carbide powder according to this embodiment may include an oxide film satisfying the above ratios of the average particle diameter (D50) to the thickness of the oxide film.

Accordingly, the silicon carbide powder according to this embodiment may protect the interior from external impurities. Accordingly, the silicon carbide powder according to this embodiment may be appropriately used as a raw material for manufacturing silicon carbide.

In addition, since the thickness of the oxide film may be appropriately controlled when a silicon carbide ingot and a silicon carbide wafer are manufactured using the silicon carbide powder according to this embodiment, defects of the silicon carbide ingot and the silicon carbide wafer may be reduced.

In particular, since an oxide film is included in an appropriate thickness on the surface of the silicon carbide powder, the oxide film may be removed in an initial heat treatment operation inside the apparatus for growth of the silicon carbide ignot. Accordingly, the oxide film on the surface of the silicon carbide powder may be removed during the initial heat treatment process, and defects due to residual oxygen during the growth process of the silicon carbide ingot may be minimized.

In addition, the oxide film may appropriately act as a protective film, thereby preventing the silicon carbide powder from being contaminated by impurities. Accordingly, when the silicon carbide powder according to this embodiment is used in the process of manufacturing the silicon carbide ingot, the inflow of impurities may be minimized.

Accordingly, the silicon carbide powder according to this embodiment may provide a silicon carbide ingot with fewer defects.

The silicon carbide powder according to this embodiment has a very high purity and may be used to manufacture a silicon carbide wafer having improved performance.

Referring to FIGS. 7 and 8, a silicon carbide wafer according to one embodiment can be manufactured as follows.

First, when a silicon carbide ingot is manufactured according to this embodiment, the silicon carbide ingot is manufactured by applying the physical vapor transport (PVT) method to produce a silicon carbide ingot having a large area and few defects.

A method of manufacturing a silicon carbide ingot 12 according to thus embodiment may include a preparation operation, a silicon carbide powder-loading operation and a growth operation.

The preparation operation is an operation of preparing a crucible assembly including a crucible body 20 having an inner space and a crucible cover 21 for covering the crucible body.

The silicon carbide powder-loading operation is an operation of loading a silicon carbide powder 30 in the crucible assembly and placing a seed tablet on the raw material at a certain distance from the raw material.

The crucible body 20 may have, for example, a cylindrical shape having an open upper surface and a structure in which a silicon carbide raw material can be loaded. The crucible body 20 may have a density of 1.70 g/cm³ to 1.90 g/cm³. A material of the crucible body 20 may include graphite.

The crucible cover 21 may be a density of 1.70 g/cm³to 1.90 g/cm³. The material of the crucible cover 21 may include graphite. The crucible cover 21 may cover the entire opening of the crucible body 20.

The crucible cover 21 may cover a portion of the opening of the crucible body 20 or include a through hole. The rate of vapor transfer in a crystal growth atmosphere (to be described later) can be adjusted.

In addition, a seed tablet holder 22 is disposed on the crucible cover 21. The seed tablet holder 22 may be coupled to the crucible cover 21. The seed tablet holder 22 may be attached to the crucible cover 21. The seed tablet holder 22 may be integrally formed with the crucible cover 21.

The thickness of the crucible cover 21 may be about 10 mm to about 50 mm. In addition, the thickness of the seed tablet holder 22 may be about 1 mm to about 10 mm.

To manufacture the silicon carbide ingot, a seed tablet was prepared. The seed tablet may be any one of silicon carbide wafers to which an off angle, which is an angle selected from a range of 0 to 8 degrees with respect to the (0001) plane, is applied.

The seed tablet may be a 4H SiC ingot that is a substantially single crystal with minimal defects or polymorphic inclusions. The silicon carbide seed tablet may be substantially made of 4H SiC.

The seed tablet may have a diameter of 4 inches or more, 5 inches or more, even 6 inches or more. More specifically, the seed tablet may have a diameter of 4 to 12 inches, 4 to 10 inches, or 6 to 8 inches.

The seed tablet is attached to a seed tablet holder. The seed tablet holder contains graphite. The seed tablet holder may be made of graphite. The seed tablet holder may include anisotropic graphite. In more detail, the seed tablet holder may be formed of anisotropic graphite.

In addition, the seed tablet and the seed tablet holder are adhered to each other by an adhesive layer. The adhesive layer includes a graphite filler and a carbide such as a phenolic resin. The adhesive layer may have a low porosity.

The C surface (0001) side of the silicon carbide seed tablet may be placed facing downward.

Next, the silicon carbide powder according to one embodiment was loaded to manufacture the silicon carbide ingot in the crucible.

A silicon carbide powder 30 includes a carbon source and a silicon source. Specifically, the silicon carbide powder 30 includes a carbon-silicon source. The silicon carbide powder 30 may have the characteristics described above. In addition, the silicon carbide powder 30 may be manufactured according to the methods described above.

The silicon carbide powder 30 having a particle size of 75 um or less may be included in an amount of 15 % by weight or less, 10 % by weight or less, or 5 % by weight or less based on the total raw material. When a raw material includes small particles in a relatively small content, a silicon carbide ingot that can reduce the occurrence of defects in an ingot, is more advantageous in controlling supersaturation, and can provide a wafer with improved crystal characteristics can be manufactured.

The silicon carbide powder 30 may be necked or non-necked to each other. When a raw material having the particle diameter is applied, a silicon carbide ingot that can provide a wafer with better crystal characteristics can be manufactured.

In the silicon carbide powder-loading operation, the crucible assembly may have a weight ratio (Rw) that is 1.5 to 2.7 times the weight of the silicon carbide powder 30 when the weight of the silicon carbide powder 30 is normalized to 1. Here, the weight of the crucible assembly means the weight of the crucible assembly excluding the raw material. Specifically, the weight of the crucible assembly is a value obtained by excluding the weight of any added raw material from the weight of the crucible assembly including a seed tablet, regardless of whether a seed holder is applied to the crucible assembly.

If the weight ratio is less than 1.5, supersaturation increases excessively in the crystal growth atmosphere, so that the crystal quality of the ingot may rather deteriorate. If the weight ratio exceeds 2.7, supersaturation decreases so that the crystal quality of the ingot may deteriorate.

The weight ratio may range from 1.6 to 2.6 or 1.7 to 2.4. Within these weight ratios, an ingot with excellent defect characteristics and crystallinity characteristics can be manufactured.

When the diameter of the inner space of the crucible body 20 is normalized to 1, the length ratio, which is a ratio of the length from the bottom surface, where the silicon carbide powder 30 is located, of the crucible assembly to the surface of a seed tablet 11, may be greater than 1 times and less than 2.5 times.

The growth operation is an operation in which the inner space of the crucible body 20 is adjusted to a crystal growth atmosphere to vapor-transfer and deposit the raw material to the seed tablet and prepare a silicon carbide ingot grown from the seed tablet.

The growth operation may include an operation of adjusting the inner space of the crucible assembly to a crystal growth atmosphere. Specifically, a reaction vessel containing the crucible assembly and an insulator 40 surrounding the crucible assembly may be prepared by wrapping the crucible assembly with an insulator 40, and the crucible, etc. may be heated using a heating device after placing the reaction vessel in a reaction chamber such as a quartz tube.

The reaction vessel was placed in a reaction chamber 42, and the inner space of the crucible body 20 was brought to a temperature suitable for a crystal growth atmosphere using a heating device 50. This temperature is one of the important factors for the crystal growth atmosphere and forms a more suitable crystal growth atmosphere by adjusting conditions such as pressure and gas movement. The insulator 40 may be located between the reaction chamber 42 and the reaction vessel to facilitate the formation and control of the crystal growth atmosphere.

The insulator 40 may affect the temperature gradient inside the crucible body or the reaction vessel in a growing atmosphere. Specifically, the insulator 40 may include a graphite insulator 40. More specifically, the insulator 40 may include a rayon-based graphite felt or a pitch-based graphite felt.

In one embodiment, the insulator 40 may have a density ranging from about 0.12 g/cc to about 0.30 g/cc. In another embodiment, the insulator 40 may have a density ranging from about 0.13 g/cc to about 0.25 g/cc. In another embodiment, the insulator 40 may have a density ranging from about 0.14 g/cc to about 0.20 g/cc.

When the density of the insulator 40 is less than about 0.14 g/cc, an ingot may grow in a concave shape, and 6H-SiC polymorphism may occur, thereby deteriorating the quality of the ingot.

When the density of the insulator 40 exceeds about 0.30 g/cc, an ingot may grow excessively convex, and the growth rate of the edges thereof may decrease, which may decrease the yield or increase the occurrence of cracks in the ingot.

When an insulator 40 having a density ranging from about 0.12 g/cc to about 0.30 g/cc is applied, the quality of the ingot may be improved. When an insulator 40 having a density ranging from about 0.14 g/cc to about 0.20 g/cc is applied, a crystal growth atmosphere can be controlled in an ingot growth process and an ingot of better quality can be grown.

The insulator 40 may have a porosity ranging from about 73 vol% to about 95 vol%. The insulator 40 may have a porosity ranging from about 76 vol% to about 93 vol%%. The insulator 40 may have a porosity ranging from 81 vol% to 91 vol%. When an insulator 40 having such a porosity is applied, the frequency of cracks in the ingot may be further reduced.

The insulator 40 may have a compressive strength of about 0.21 Mpa or more. The insulator 40 may have a compressive strength of about 0.49 Mpa or more. The insulator 40 may have a compressive strength of about 0.78 MPa or more. In addition, the insulator 40 may have a compressive strength of about 3 MPa or less or a compressive strength of about 25 MPa or less. When the insulator 40 has such a compressive strength, excellent thermal/mechanical stability is exhibited, and iSiC ingots of better quality can be manufactured because the probability of ash is reduced.

The insulator 40 may be applied to a thickness of about 20 mm or more or a thickness of about 30 mm or more. In addition, the insulator 40 may be applied to a thickness of about 150 mm or less, a thickness of about 120 mm or less, or a thickness of about 80 mm or less. When the thickness of the insulator 40 is limited to the ranges, sufficient insulation effect can be obtained without unnecessary waste of an insulator 40.

The insulator 40 may have a density ranging from about 0.12 g/cc to about 0.30 g/cc. The insulator 40 may have a porosity ranging from about 72 vol% to about 90 vol%. When such an insulator 40 is applied, it is possible to suppress the shape of an ingot from growing concave or excessively convex, and it is possible to reduce the deterioration of polymorphic quality or the occurrence of cracks in the ingot.

The crystal growth atmosphere may be implemented by heating the heating device 50 outside the reaction chamber 42, the air may be removed by reducing the pressure simultaneously with or separately from the heating, and a reduced pressure atmosphere and/or an inert atmosphere (e.g., Ar atmosphere, N₂ atmosphere or a mixture thereof) may be implemented.

The crystal growth atmosphere induces the growth of a silicon carbide crystal by allowing a raw material to vapor-transfer on the surface of a seed tablet to grow into the ingot 12.

The crystal growth atmosphere may be implemented under conditions such as a growth temperature ranging from 2100 °C to 2450 °C and a growth pressure ranging from 1 Torr to 100 Torr. When such a temperature and pressure are applied, a silicon carbide ingot may be more efficiently manufactured.

Specifically, in the crystal growth atmosphere, the upper and lower surface temperatures as the growth temperature of the crucible may range from 2100 °C to 2450 °C and the growth pressure thereof may range from 1 Torr to 50 Torr. More specifically, the upper and lower surface temperatures as the growth temperature of the crucible may be 2150 °C to 2450 °C and the growth pressure thereof may range from 1 Torr to 40 Torr.

More specifically, the upper and lower surface temperatures as the growth temperature of the crucible may be 2150 °C to 2350 °C and the growth pressure thereof may be 1 Torr to 30 Torr.

The manufacturing method of the present disclosure can more advantageously manufacture a higher-quality silicon carbide ingot by applying the crystal growth atmosphere described above.

The silicon carbide ingot 12 contains 4H-SiC and may have a convex or flat surface.

If the surface of the silicon carbide ingot 12 is formed in a concave shape, other polytypes, such as 6H-SiC, in addition to the intended 4H-SiC crystal may be mixed, which may degrade the quality of the silicon carbide ingot. In addition, the surface of the silicon carbide ingot is formed in an excessively convex shape, cracks may occur in the ingot itself or crystals may be broken when processed into wafers.

Here, whether the silicon carbide ingot 12 is an excessively convex ingot is determined based on the degree of warp, and a silicon carbide ingot manufactured in this specification has a warp ranging from about 20 mm or less.

The warp is evaluated as a value of (center height - edge height) by placing a sample, on which the growth of a silicon carbide ingot is completed, on a surface plate and measuring the heights of the center and edge of the ingot based on the back of the ingot with a height gauge. A positive value of warp means convex, a value of 0 means flat, and a negative value means concave.

Specifically, the silicon carbide ingot 12 may have a convex or flat surface and a warp of 0 mm to about 14 mm, a warp ranging from about 0 mm to about 11 mm, or a warp ranging from about 0 mm to about 8. A silicon carbide ingot with such a warp degree can make wafer processing easier and reduce the occurrence of cracks.

The silicon carbide ingot 12 may be a 4H-SiC ingot that is a substantially single crystal with minimized defects or polymorphic mixing. The silicon carbide ingot 12 may be formed of substantially 4H-SiC and may have a convex or flat surface.

The silicon carbide ingot 12 may have a reduced number defects of the type that can occur in a silicon carbide ingot, and thus provide a higher-quality silicon carbide wafer.

The silicon carbide ingot manufactured by the method of the present specification may reduce the pit density on the surface thereof. Specifically, the pit density in the surface of an ingot with a diameter of 4 inches or more may be about 10,000 pits/cm² can be or less.

In this specification, to evaluate the surface pit of the silicon carbide ingot, a total of 5 locations, i.e., one location in the center of the ingot surface excluding facets and four locations at 3 o'clock, 6 o'clock, 9 o'clock, and 12 o'clock directions located approximately 10 mm inside from the edge of the silicon carbide ingot toward the center, is observed with an optical microscope, and the pit per unit area (1 cm²) is measured at each location, and the average value thereof is obtained.

For example, the outer rim of the silicon carbide ingot may be trimmed using external grinding equipment, sliced to a certain thickness, and subjected to processing such as edge grinding, surface polishing, and polishing.

The slicing operation is an operation of preparing a sliced crystal by slicing a silicon carbide ingot to have a certain off-angle. The off-angle is based on the (0001) plane in 4H SiC. The off-angle may be an angle selected from specifically 0 to 15 degrees, 0 to 12 degrees, or 0 to 8 degrees.

The slicing may be applied if it is a slicing method normally applied to wafer manufacturing, and for example, cutting using a diamond wire or a wire to which diamond slurry is applied, cutting using a blade or wheel to which diamond is partially applied, etc. may be applied. However, the cutting may not be limited thereto.

The thickness of the sliced crystal may be adjusted in consideration of the thickness of the wafer to be manufactured, and the sliced crystal may be sliced to an appropriate thickness in consideration of the thickness after polishing in a polishing operation described below.

The polishing operation is an operation of forming a silicon carbide wafer by polishing the sliced crystal to a thickness of 300 to 800 um.

For the polishing operation, a polishing method normally applied to wafer manufacturing may be applied, and exemplarily, a method in which lapping and/or grinding, etc. are performed, followed by polishing, etc. may be applied.

The silicon carbide wafer according to one embodiment may have a low surface oxygen concentration. In the silicon carbide wafer according to one embodiment, a surface oxygen concentration measured by the X-ray photoelectron spectroscopy may range from about 5 atom% to about 14 atom%. In the silicon carbide wafer according to one embodiment, a surface oxygen concentration measured by the X-ray photoelectron spectroscopy may range from about 6 atom% to about 13 atom%. In the silicon carbide wafer according to one embodiment, a surface oxygen concentration measured by the X-ray photoelectron spectroscopy may range from about 7 atom% to about 12.5 atom%. In the silicon carbide wafer according to one embodiment, a surface oxygen concentration measured by the X-ray photoelectron spectroscopy may range from about 8 atom% to about 12 atom%.

Accordingly, since the silicon carbide wafer according to one embodiment has a low surface oxygen content, a high yield may be realized when used in the process of manufacturing a power semiconductor device. The silicon carbide wafer according to one embodiment may have a yield of about 88% or more for a power semiconductor device to be fabricated. That is, a method of fabricating a power semiconductor device using the silicon carbide wafer according to one embodiment may provide a yield of about 88% or more.

Hereinafter, the embodiment will be specifically described through specific examples. The following examples are merely examples to aid understanding of the embodiment, and the scope of the present disclosure is not limited thereto.

### Manufacturing Example 1

A monocrystalline silicon carbide lump was provided as a silicon carbide raw material. The monocrystalline silicon carbide lump may be formed by sublimating a silicon carbide powder with a purity of about 99.9999% or more at about 2300 °C and depositing it on a seed tablet.

The monocrystalline silicon carbide lump was first pulverized by a jaw crusher (Henan Dewo Industrial Limited Company, KER-100 × 60). A primary powder having a particle diameter (D50) ranging from about 1 mm to 6 mm was obtained from the crushed silicon carbide lump.

Next, the primary powder was secondarily pulverized by a ball mill (Ganzhou Li Ang Machinery Co., Ltd., QM400 * 600). The secondarily pulverized primary powder was classified with a classifier, and a secondary powder having an average particle diameter (D50) of about 500 µm was obtained.

Next, the secondary powder was heat treated for about 24 hours at about 1200 °C in an air atmosphere, thereby removing free carbon and free silicon.

Next, the heat-treated silicon carbide powder was purified by a wet etching process.

Deionized water, an aqueous hydrofluoric acid solution (aqueous solution at a concentration of 30 wt%) and an aqueous nitric acid solution (aqueous solution at a concentration of 30 wt%) were mixed in a weight ratio of about 3: 1.5: 1.5, thereby manufacturing an etchant.

Next, about 1 ℓ (apparent volume) of the heat-treated silicon carbide powder was put into an etching container having a volume of about 5 ℓ, and about 0.8 ℓ of the etchant was added.

Next, the etching container was sealed with a lid. Here, an oil vapor generated in the etching container was discharged through the lid, and the oil vapor was recovered by the scrubber.

The etchant and the heat-treated silicon carbide powder were stirred for about 1 hour at a speed of about 26 rpm.

Next, the etchant was drained, and the wet-etched silicon carbide powder was neutralized by deionized water in the following process. The wet-etched silicon carbide powder was immersed in deionized water and, after stirring, the deionized water was discharged. The immersion and discharge processes were repeated until the pH of the discharged deionized water reached 7.

Next, the neutralized silicon carbide powder was dried at about 80 °C for about 30 minutes.

Next, the dried silicon carbide powder was placed in a graphite crucible.

Next, an inner temperature of the crucible was elevated up to about 2000 °C, and the pressure inside the crucible was reduced to about 8 Torr.

Next, an etching gas in which an argon gas and a chlorine gas were mixed in a volume ratio ranging from about 10: 1 was added into the crucible, and the pressure inside the crucible was elevated to about 760 Torr. Here, the temperature of the crucible was set so that the temperature of a lower part of the crucible was about 50 °C higher than the temperature of an upper part of the crucible. This condition was maintained for about 2 days.

Next, an etching gas inside the crucible was recovered with a scrubber, and the inside of the crucible where the dry-etched silicon carbide powder was disposed was heat-treated at about 1000 °C in an air atmosphere for about 10 hours.

Next, the heat-treated silicon carbide powder was immersed in a surface treatment liquid as shown in Table 1 below, and the silicon carbide powder and the surface treatment liquid were stirred for about 1 hour.

Next, the silicon carbide powder treated with the aqueous hydrofluoric acid solution was immersed in ultrapure water, sufficiently mixed, and washed by repeating the process in which the ultrapure water was drained. Here, the immersion process and the draining process were repeated until the concentration of citric acid included in the drained ultrapure water was lowered to about 0.0001 wt% or less.

### Manufacturing Examples 2 to 4

Experiments were carried out in the substantially same manner as in Manufacturing Example 1, and an etchant and an etching gas were used as in Tables 1 and 2 below.

**Table 1**

| Classification | Deionized water (parts by weight) | Citric acid (parts by weight) | Hydrogen peroxide (parts by weight) |
|---|---|---|---|
| Manufacturing Example 1 | 245 | 1 | 4 |
| Manufacturing Example 2 | 43 | 1 | 1 |
| Manufacturing Example 3 | 196 | 1 | 3 |
| Manufacturing Example 4 | 97 | 1 | 2 |

**Table 2**

| Classification | Argon (sccm) | Chlorine gas (sccm) |
|---|---|---|
| Manufacturing Example 1 | 100 | 10 |
| Manufacturing Example 2 | 100 | 50 |
| Manufacturing Example 3 | 100 | 100 |
| Manufacturing Example 4 | 100 | 100 |

### Examples

Next, the silicon carbide powder manufactured in Manufacturing Example 1 was loaded into a graphite crucible body. A silicon carbide seed tablet and a seed tablet holder were placed on the top of the powder. Here, the C surface (0001) of the silicon carbide seed tablet (4H-SiC single crystal, 6 inches) was fixed in a general method to face the bottom of the crucible. In addition, a crucible cover and a seed tablet holder were integrally formed with graphite, and both the crucible cover and the seed tablet holder had a disc shape. Here, the thickness of the crucible cover was about 20 mm, the diameter of the crucible cover was about 210 mm, the thickness of the seed tablet holder was about 3 mm, and the diameter of the seed tablet holder was about 180 mm.

The crucible main body was covered with a crucible cover in which the seed tablet and the seed tablet holder were installed, surrounded by the insulator 40, and placed in a reaction chamber equipped with a heating coil 50 as a heating device.

Here, a graphite felt having a density of about 0.19 g/cc, a porosity of about 85 vol%, and a compressive strength of about 0.37 MPa was applied as an insulator.

After evacuating the inside of the crucible, argon gas was slowly injected thereinto so that the inside of the crucible reached atmospheric pressure, and then the inside of the crucible was gradually decompressed. At the same time, the temperature inside the crucible was gradually elevated up to 2000 °C at a heating rate of about 3 °C/min and gradually elevated to 2350 °C at a heating rate of about 5 °C/min.

Next, a SiC ingot was grown from a silicon carbide seed tablet for 100 hours under conditions of 2350 °C and a pressure of 20 Torr.

Next, the silicon carbide ingot was cut by a diamond wire saw and processed by chamfering, grinding and polishing processes. Accordingly, a silicon carbide wafer with an angle-off of 4 degrees with respect to the (0001) plane was manufactured.

### Examples 2 to 4 and Comparative Examples 1 and 2

As shown in Table 3 below, experiments were carried out in the same manner as in Example 1 except that the silicon carbide powder was changed.

**Table 3**

| Classification | Silicon carbide powder |
|---|---|
| Example 1 | Manufacturing Example 1 |
| Example 2 | Manufacturing Example 2 |
| Example 3 | Manufacturing Example 3 |
| Example 4 | Manufacturing Example 4 |
| Comparative example 1 | Carborex manufactured by Washington Mills |
| Comparative example 2 | Green Silicon Carbide manufactured by Pacific Rundum |

### Measurement examples

### 1. Purity of silicon carbide powder

The purity of the silicon carbide powder according to the manufacturing example was measured by glow discharge mass spectrometry.

### 2. Shape of silicon carbide powder

The silicon carbide powder manufactured in the manufacturing example was taken by an optical microscope (Eclipse LV150 Microscope, manufactured by Nikon) and analyzed by an image analysis program (i-solution, manufactured by IMT).

### 3. XPS analysis

XPS equipment name/manufacturer: K-Alpha+ / ThermoFisher Scientific

### Measurement conditions

1) X-ray source: Monochromated Al X-Ray sources (Al Kα line: 1486.6eV)
2) X-Ray power: 12kV, 10mA
3) Sampling area: 400um (diameter)
4) Narrow scan: pass energy 40eV, step size 0.05eV
5) Vacuum: 3 × 10⁻⁹ mbar
6) Calibration: No
7) Flood gun is used for charge compensation ON

### <Etching conditions>

Ar ion etching: 2 keV, 1500sec, raster size 2 × 2mm

### 4. Oxide film thickness

Pretreatment process: A silicon carbide powder was fixed through a platinum deposition process, and after cutting, the cut surface thereof was photographed by TEM.
Equipment name: Libra 200 MC TEM
Manufacturer: Carl Zeiss
Gun Type: ZrO/W-field emitter system (Schottky emitter)
Attachment: Monochromator (CEOS, Germany)
Imaging Cs-Corrector (CEOS, Germany)
Corrected OMEGA in-column energy filter
CCD Camera
ORIUS SC200D (Gatan, U.S.)
UltraScan 1000XP (Gatan, U.S.)
EDS Detector (X-Max 80T, Oxford, U.K.)

### 5. Wafer fabrication device yield

An epitaxial layer having a thickness of about 10 µm was formed on the silicon carbide wafer manufactured in each of the examples and the comparative Examples. Next, about 3922 power semiconductor devices were formed, and each power semiconductor device was checked for defects.

**Table 4**

| Classification | Purity (%) | Average particle diameter (D50, µm) | Oxide film thickness (nm) |
|---|---|---|---|
| Example 1 | 99.9999 or more | 450 | 5.5 |
| Example 2 | 99.9999 or more | 150 | 1.2 |
| Example 3 | 99.9999 or more | 240 | 3.4 |
| Example 4 | 99.9999 or more | 200 | 2.2 |
| Comparative example 1 | 99.9% | 250 | 13 |
| Comparative example 2 | 99.9% | 150 | 15 |

**Table 5**

| Classification | O1s/C1s | O1s/Si2p |
|---|---|---|
| Example 1 | 0.202 | 0.381 |
| Example 2 | 0.238 | 0.293 |
| Example 3 | 0.220 | 0.352 |
| Example 4 | 0.226 | 0.366 |
| Comparative example 1 | 0.399 | 0.518 |
| Comparative example 2 | 0.299 | 0.398 |

**Table 6**

| Classification | Power semiconductor device yield (%) |
|---|---|
| Example 1 | 91 |
| Example 2 | 90 |
| Example 3 | 91 |
| Example 4 | 90 |
| Comparative example 1 | 87 |
| Comparative example 2 | 85 |

As shown in Tables 4 to 6, the silicon carbide powders manufactured according to the examples have an oxide film thickness ranging from 1.3 to 5.5 nm and less than 10 nm. In addition, the silicon carbide wafers fabricated according to the examples have improved power semiconductor device yields.

### Description of Symbols

seed tablet 11
silicon carbide ingot 12
crucible body 20
crucible cover 21
seed tablet holder 22
silicon carbide powder 30
reaction chamber 42
insulator 40
heating device 50

## Claims

1. A method of manufacturing a silicon carbide wafer, the method comprising:
preparing a silicon carbide powder comprising carbon, silicon and an oxide film having a thickness ranging from 0.1 nm to 10 nm;
growing a silicon carbide ingot using the silicon carbide powder; and
processing the silicon carbide ingot.

2. The method of manufacturing a silicon carbide wafer according to claim 1, wherein the silicon carbide powder comprises a core comprising silicon carbide, and
the oxide film is disposed around the core.

3. The method of manufacturing a silicon carbide wafer according to claim 1, wherein a thickness of the oxide film ranges from 0.5 nm to 8 nm.

4. The method of manufacturing a silicon carbide wafer according to claim 1, wherein a thickness of the oxide film ranges from 0.7 nm to 6 nm.

5. The method of manufacturing a silicon carbide wafer according to claim 1, wherein the silicon carbide powder has an average particle diameter ranging from 100 µm to 1000 µm.

6. The method of manufacturing a silicon carbide wafer according to claim 5, wherein a ratio of the thickness of the oxide film to the average particle diameter of the silicon carbide powder ranges from 1×10⁻⁷:1 to 1×10⁻⁵:1.

7. The method of manufacturing a silicon carbide wafer according to claim 1, wherein O1s/Si2p of a surface measured by X-ray photoelectron spectroscopy is 0.39 or less, and O1s/C1s of the surface measured by X-ray photoelectron spectroscopy is 0.28 or less.
